# EUROPÄISCHE PATENTANMELDUNG

(11) **EP 3 621 098 A1**
(43) Veröffentlichungstag der Anmeldung: **11.03.2020**
(21) Anmeldenummer: 18192459.8
(22) Anmeldetag: 04.09.2018
(51) Int. Cl.: H01J 37/04, H01J 37/08, H01J 37/147, F03H 1/00

(54) **VORRICHTUNG ZUR ERZEUGUNG VON IONENSTRAHLEN MIT ANPASSBAREN IONENSTRAHLPROFILEN**

(71) Anmelder: Justus-Liebig-Universität Gießen, 35390 Gießen (DE)
(72) Erfinder: Becker, Martin, 35625 Hüttenberg-Reiskirchen (DE); Chatterjee, Sangam, 35037 Marburg (DE); Holste, Kristof, 35390 Gießen (DE); Klar, Peter, 35392 Gießen (DE)
(74) Vertreter: Stumpf, Peter

(57) **Zusammenfassung**

Die Erfindung betrifft eine Vorrichtung 10 zur Erzeugung von lonenstrahlen mit anpassbaren lonenstrahlprofilen, welche wenigstens ein Plasmagefäß 20 einer lonenquelle mit wenigstens zwei lonenoptiken 25,26 und einem lonenoptikwechsler 28 umfasst. Dabei ist der lonenoptikwechsler 28 so ausgebildet ist, dass er die lonenoptiken 25,26 zwischen zwei Positionen verschieben kann und dabei der vom Plasmagefäß der lonenquelle 20 ausgehende lonenstrahl in einer ersten Position eine erste lonenoptik 25 und in wenigstens einer weiteren Position alternativ eine zweite lonenoptik 26 durchlaufen kann.

## Beschreibung

### Vorrichtung zur Erzeugung von lonenstrahlen mit anpassbaren Ionenstrahlprofilen

Die vorliegende Erfindung betrifft eine Vorrichtung zur Erzeugung von Ionenstrahlen mit anpassbaren Ionenstrahlprofilen beispielsweise zur Sputter-Deposition oder zur Schuberzeugung im Weltraum.

### Beschreibung und Einleitung des allgemeinen Gebietes der Erfindung

Ionenquellen oder auch Ionentriebwerke stellen einen gerichteten lonenstrahl zur Verfügung. Im Falle der Ionenquellen für die Materialbearbeitung wird dieser Ionenstrahl genutzt, um ein Material zu bearbeiten, indem es dem lonenstrahl aussetzt wird. Im Falle der Ionentriebwerke wird der aufgrund der Impulserhaltung auftretende Rückstoß bei Ausstoß des lonenstrahls genutzt, um ein Raumfahrzeug, auf dem sich das Ionentriebwerk befindet, anzutreiben.

Im Allgemeinen sind die Strahlprofile von Ionenquellen oder Ionentriebwerken nur in geringen Grenzen variabel, d.h. insbesondere ist die grundsätzliche Form des räumlichen Profils (z.B. Gauß-Profil) durch die Konstruktionselemente der Quelle oder des Triebwerks vorgegeben. Änderungen der Betriebsparameter der Ionenquelle im spezifizierten Bereich führen i A. zu einer Änderung der Ionenenergie oder der Strahlintensität, wobei sich die grundsätzliche Form des räumlichen Profils abgesehen von einer Strahlaufweitung oder -verschmälerung nicht ändert. Häufig werden Ionenquellen oder Ionentriebwerke eingesetzt, bei denen die Ionen aus einem Plasma mit Hilfe eines Gittersystems extrahiert werden. Dieses Gittersystem wirkt auch als Ionenoptik und wird genutzt, um das Strahlprofil des extrahierten lonenstrahls zu definieren. Das in der lonenquelle verbaute Gittersystem legt bei Gitter-Ionenquellen und Gitter-Ionentriebwerken das räumliche Profil des extrahierten lonenstrahls für eine Anwendung fest. Ist das räumliche Profil so festgelegt, dann ist es durch die Betriebsparameter nicht veränderbar. Darüber hinaus muss der Bereich der Betriebsparameter des Gittersystems so gewählt werden, dass dieses bei der Extraktion der Ionen nicht durch Über- oder Unterfokussierung geschädigt wird, was die Variabilität im Strahlprofil, in der extrahierten Intensität des lonenstrahls und in der Energieverteilung der Ionen im Strahl zusätzlich einschränkt. Außerdem können sich die optimalen Betriebsbedingungen stark ändern, wenn das Gas oder die Gasmischung, die als Betriebsmittel zur Plasmaerzeugung in der lonenquelle eingesetzt wird, gewechselt wird. Eine größere Variabilität in diesen vier wichtigen Kenngrößen ist für eine Vielzahl von Anwendungen sowohl in der Materialbearbeitung/-deposition als auch im Bereich der Schuberzeugung im Weltraum wünschenswert.

Beim Beschuss einer Oberfläche mit Ionen können, abhängig von den verwendeten Ionen und ihrer kinetischen Energie, verschiedene Effekte auftreten:
- Die Ionen kondensieren auf dem beschossenen Substrat und bilden dort eine Schicht. Dies wird als Ionenstrahldeposition bezeichnet. Dies geschieht vorwiegend bei kleinen Energien.
- Material vom beschossenen Target wird als Sekundäremissionskeule (Sekundärplume) abgetragen. Dies wird als Sputtern bezeichnet. Dies geschieht vorwiegend bei mittleren Energien.
- Die Ionen werden in das Targetmaterial eingebaut und gehen dort gegebenenfalls eine chemische Verbindung ein. Dieser Effekt wird (reaktive) Ionenimplantation genannt. Dies geschieht vorwiegend bei hohen Energien.

Ist ein Materialabtrag beabsichtigt, so müssen die Ionen dafür eine gewisse Mindestenergie besitzen. Das auftreffende Ion überträgt seinen Impuls auf Atome des Targets, des beschossenen Materials, die dann in einer Stoßkaskade weitere Kollisionen auslösen. Nach mehreren Kollisionen hat ein Teil der Targetatome einen Impuls, der vom Targetinneren fortweist. Befindet sich ein solches Atom in der Nähe der Oberfläche und hat es eine hinreichend hohe Energie, kann es das Target verlassen.

Ionenstrahl-Sputterdeposition und Ionenstrahlverdichten sind als Methoden der Dünnschichttechnologie prinzipiell aus der Literatur bekannt. In lonenstrahl-Sputter-Systemen werden die einfallenden Ionen in einer lonenquelle erzeugt, während sich das Target in einem lokal von der lonenquelle getrennten Bereich der Prozesskammer befindet. Zur lonenstrahl-Sputterdeposition bringt man in die Nähe des Targets zusätzlich ein Substrat, sodass die herausgeschlagenen Target-Atome auf diesem kondensieren und eine Schicht bilden können. Der Gasdruck in der Prozesskammer muss in diesem Prozess gering sein (Vakuum), damit die Targetatome das Substrat erreichen, ohne mit anderen Gasteilchen zusammenzustoßen. Das heißt, die mittlere freie Weglänge der Gasteilchen muss mindestens dem Abstand des Targets zum Substrat entsprechen. Bei einem Abstand von ca. 30 cm sollte der Gasdruck daher nicht größer als ca. 2×10⁻⁴ mbar (Hochvakuum) sein, andernfalls sind schlechtere Schichteigenschaften die Folge. Da die Substrate nicht der Entladung oder dem Strahl direkt ausgesetzt sind, werden sie nicht stark erwärmt. Daher kann nahezu jedes Material, das gesputtert werden kann, auf temperaturempfindlichen Substraten abgeschieden werden.

Schuberzeugung bei Raumfahrzeugen mit Hilfe von Ionentriebwerken ist aus der Literatur bekannt. Ionentriebwerke sind aufgrund der hohen Austrittsgeschwindigkeiten der Ionen von bis zu 30 km/s masseneffizient zu betreiben, daher ist ihr Einsatz im Weltraum vorteilhaft. Schübe im Bereich von Mikro-Newton bis Newton sind realisierbar mit Ionentriebwerken unterschiedlicher Größe. Dies erlaubt es, Ionentriebwerke in unterschiedlichen Missionsszenarien einzusetzen. Dazu gehören der Einsatz zur Bahnregelung bei kleinen Schüben ebenso der Einsatz als Marschtriebwerk beim Aufspiralen von Satelliten in ihren Zielorbit oder bei wissenschaftlichen Missionen wie z.B. zum Mars. Bei den häufig genutzten Gitter-Ionentriebwerken bestimmen, die am Gittersystem angelegten Spannungen und die Anordnung und Größe der Gitteröffnungen der einzelnen Gitter des Systems zusammen mit den Plasmaparametern im Inneren des Triebwerks die Funktion der Ionenoptik. Die optimale Einstellung der Ionenoptik variiert mit dem zu erzeugenden Schub sowie mit dem im Plasma eingesetzten Betriebsmittel (Treibstoff).

### Stand der Technik

Ionenquellen für die Materialbearbeitung und Ionentriebwerke für die Schuberzeugung sind baulich bedingt in der Variabilität des räumlichen Profils, der Energieverteilung und der extrahierten Intensität eingeschränkt. Außerdem unterscheiden sich die optimalen Betriebsparameter für verschiedene Betriebsmittel stark. Für viele Anwendungen ist eine möglichst große Variabilität dieser vier Kenngrößen vorteilhaft.

Mit gängigen Beschichtungssystemen ist es heute nicht möglich, routinemäßig in Produktionslinien nichtplane Oberflächen, d. h. Freiformen und insbesondere auch Freiform-Optiken, konform mit Multischichten zu versehen. In der Praxis wird derzeit auf hochkomplexe und damit mechanisch sehr anfällige Planetengetriebe im Vakuum zurückgegriffen, um einzelne Freiformen zu beschichten. Konformität wird dadurch erzielt, dass das zu beschichtende Objekt während des Beschichtungsprozesses bewegt werden muss.

Im Falle der Materialdeposition sind konventionelle Techniken der Dünnschichtbearbeitung zumeist für planare Substrate optimiert. Die Methode der Atomlagendeposition (ALD) stellt hierbei eine Ausnahme dar und erlaubt prinzipiell die selbstterminierte Beschichtung beliebig geformter Oberflächen. ALD-Beschichtungen werden jedoch Atomlage für Atomlage aufgebaut und unterliegen daher vergleichsweise geringen Depositionsraten. Ein wirtschaftlicher Einsatz ist daher stark limitiert. Im Rahmen der Verwendung von Ionenquellen basieren wirtschaftlich denkbare Prozesse bisher auf der Verwendung mehrerer Ionenquellen.

Bei den Gitter-Ionentriebwerken in der Raumfahrt sind Triebwerke, auch wenn sie in verschiedenen Betriebsmodi während der Mission betrieben werden, immer nur mit einem fest verbauten Extraktionssystem ausgestattet. Die resultierende Ionenoptik stellt einen Kompromiss dar, da sie nicht gleichzeitig für verschiedene Betriebsmodi des Triebwerks optimiert sein kann.

Mit gängigen Beschichtungssystemen ist eine konforme Beschichtung mit Multischichten nahezu nicht umsetzbar. Ein Einsatz multipler Ionenquellen mit jeweils eigener, aber generell abzustimmender Steuerelektronik, ist denkbar, aber mit hohen Kosten verbunden.

Bei Gitter-Ionentriebwerken, die während der Mission in verschiedenen Betriebsmodi mit dem gleichen Extraktionssystem arbeiten, ist die Performance nicht optimal und der Verschleiß größer als im Falle von wechselbaren auf den jeweiligen Betriebsmodus zugeschnittenen Extraktionssystemen. Daraus können Triebwerksausfälle resultieren, da keine Wartungsarbeiten im Weltraum möglich bzw. vorgesehen sind, die dann zu einem unplanmäßigen Ausfall des Satellitensystems führen können, weil z.B. keine Bahnregelung mehr möglich ist.

Von Gitterionenquellen, die als Ionenquellen für die Materialbearbeitung oder auch als Ionentriebwerke eingesetzt werden können, gibt es zwei Arten. So gibt es zum einen Gitterionenquellen, welche auf die Ausbildung hoch fokussierter Ionenstrahlen optimiert sind und damit z.B. zwecks Behandlung großflächiger Substrate bewegt werden müssen. Hoch fokussiert heißt der Fokusdurchmesser ist kleiner als 1 cm². Weiterhin gibt es Breitstrahlionenquellen. Letztere werden zur großflächigen Modifikation von Materialien (Sputtern, Ätzen etc.) eingesetzt. Großflächig bedeutet, dass Flächen von wenigstens 100 cm² bestrahlt werden können. Ebenso können Breitstrahlionenquellen als Ionentriebwerke eingesetzt werden.

### Aufgabe

Aufgabe der vorliegenden Erfindung ist es, eine Vorrichtung zur Erzeugung von lonenstrahlen mit anpassbaren Ionenstrahlprofilen bereitzustellen, welche beispielsweise die Beschichtung von Objekten von beliebiger Geometrie mit einem bestimmten Schichtdickenprofil oder den Betrieb von Gitter-Ionentriebwerken in verschiedenen Betriebsmodi mit verschiedenen Extraktionssystemen ermöglicht, was sowohl die Lebensdauer der Triebwerke erhöht als auch flexiblere Einsatzmöglichkeiten bietet.

### Lösung der Aufgabe

Die Aufgabe wird durch die Vorrichtung mit den Merkmalen des Hauptanspruchs gelöst. Vorteilhafte Weiterbildungen der Erfindung sind in den Unteransprüchen beschrieben.

### Vorrichtung:

Die erfindungsgemäße Vorrichtung 10 zur Erzeugung von lonenstrahlen mit anpassbaren Ionenstrahlprofilen umfasst dabei wenigstens einer lonenquelle mit einem Plasmagefäß 20 mit wenigstens zwei Ionenoptiken 25,26 und einem Ionenoptikwechsler 28, welcher so ausgebildet ist, dass er die Ionenoptiken 25,26 zwischen mindestens zwei Positionen verschieben kann.

Der Ionenoptikwechsler 28 ist so ausgebildet ist, dass er zwischen den Ionenoptiken 25, 26 schaltet, so dass ein von der lonenquelle emittierter lonenstrahl in einem ersten Schaltzustand des Ionenoptikwechslers 28 eine erste Ionenoptik 25 durchlaufen kann, wobei ein lonenstrahl mit einem ersten Ionenstrahlprofil erzeugt wird und in wenigstens einem weiteren Schaltzustand alternativ eine zweite Ionenoptik 26 durchlaufen kann, wobei ein lonenstrahl mit einem alternativen Ionenstrahlprofil, welches vom ersten Ionenstrahlprofil abweichen kann, erzeugt wird. Die Ionenoptiken 25, 26 sind dabei vorzugsweise in ihrer Position veränderlich ausgebildet. Mechanisches Hauptbauelement der Ionenoptiken ist dabei der jeweilige Satz an Extraktionsgittern. Dieser besteht typischerweise mindestens aus zwei oder drei einzelnen Lochgittern, welche die Anzahl und Anordnung der einzelnen Extraktionskanäle definieren. Die einzelnen Lochgitter sind gegeneinander elektrisch isoliert und werden durch eine externe Spannungsversorgung auf die benötigten elektrischen Potentiale gelegt. Dies geschieht, um die Fokussierung auf maximalen Impuls in axialer Richtung zu optimieren. Die Löcher der Lochgitter sind i. A. regelmäßig angeordnet und das Lochmuster ist i. A. für alle Gitter eines Gittersystems gleich, die Anzahl der Löcher (Austrittsöffnungen der einzelnen Beamlets,die den lonenstrahl bilden) kann zwischen 1 und 1000 variieren. Typische Lochdurchmesser liegen im Bereich von 1 mm und 1 cm. In einer Ionenoptik können die Lochdurchmesser der einzelnen Löcher der Extraktionsgitter variieren. In der bevorzugten Ausbildung der erfindungsgemäßen Vorrichtung stellen die Kombinationen aus dem Plasmagefäß 20 der lonenquelle mit Ionenoptik 25 bzw. 26 jeweils eine Gitterionenquelle dar.

Das Plasmagefäß 20 der lonenquelle weist einen Gaseinlass auf. Durch diesen Gaseinlass kann das notwendige Prozessgas eingeleitet werden.

Für die Materialbearbeitung nutzt man im Allgemeinen inerte Gase und/oder Gasgemische aus inertem Prozessgas und Reaktivgas als Betriebsmittel (auch als Prozessgas bezeichnet) in die lonenquelle. Als Inertgas wird häufig Argon eingesetzt, aber auch der Einsatz anderer Edelgase ist möglich. Bei Gasgemischen wird oft, aber nicht notwendig, ein reaktives Gas wie Sauerstoff oder Stickstoff zugesetzt, so ist es beispielweise möglich, ausgehend von metallischen Targets oxydische oder nitridische Beschichtungen herzustellen.

In Ionentriebwerken wird als Betriebsmittel (auch als Treibstoff bezeichnet) aktuell das Inertgas Xenon eingesetzt. Alternativen zu Xenon sind sowohl im Bereich der atomaren Treibstoffe z.B. Krypton als auch im Bereich der molekularen Treibstoffe z.B. Jod, Sauerstoff, Stickstoff. Auch komplexere Moleküle wie Diamantoide sind werden eingesetzt und aktueller Gegenstand der Forschung.

Weiterhin besteht das Plasmagefäß 20 der lonenquelle aus elektrisch isolierendem Material (z.B. Glas, Keramik), in welches das Betriebsmittel eingeleitet werden kann. Es ist dabei so ausgebildet, dass die Ionisationsprozesse beispielsweise durch Einkoppeln eines hochfrequenten Wechselfeldes im Inneren des Gefäßes initiiert werden können, um das Betriebsmittel zu ionisieren. Es besitzt weiterhin eine offene Seite über welche der erzeugte lonenstrahl das Plasmagefäß verlassen kann. Im Betrieb wird diese offene Seite entweder durch die Ionenoptik 25 oder durch die Ionenoptik 26 abgeschlossen. Der Ionenoptikwechsler 28 kann dabei zwischen mindestens zwei Schaltzustanden umschalten, so dass der vom Plasmagefäß 20 der lonenquelle ausgehende lonenstrahl in einem ersten Schaltzustand eine erste Ionenoptik 25 durchläuft und ein lonenstrahl mit einem ersten Ionenstrahlprofil erzeugt wird. Alternativ durchläuft der vom Plasmagefäß 20 der lonenquelle ausgehende lonenstrahl und in wenigstens einem weiteren Schaltzustand alternativ eine zweite Ionenoptik 26 durchläuft, wobei ein lonenstrahl mit einem ersten Ionenstrahlprofil erzeugt wird. Das bedeutet dass er jede dieser Ionenoptiken umfasst ein Beschleunigungsgittersystem (mindestens zwei hintereinander liegende gitterförmige Elektroden mit Extraktionskanälen). Das Beschleunigungsgittersystem ist so ausgebildet, dass die aus den Ionisationsprozessen resultierenden Ionen durch thermische Diffusion aus dem Plasma in einen der Extraktionskanäle eintreten, in Richtung des Targets extrahiert werden können und im elektrischen Feld des Beschleunigungsgittersystems Energie aufnehmen. Diese primär freigesetzten Ionen bilden dabei sogenannte Primärplumes. Typische Ionenenergien des Primärstrahls liegen im Bereich von 10 eV bis zu 10 keV.

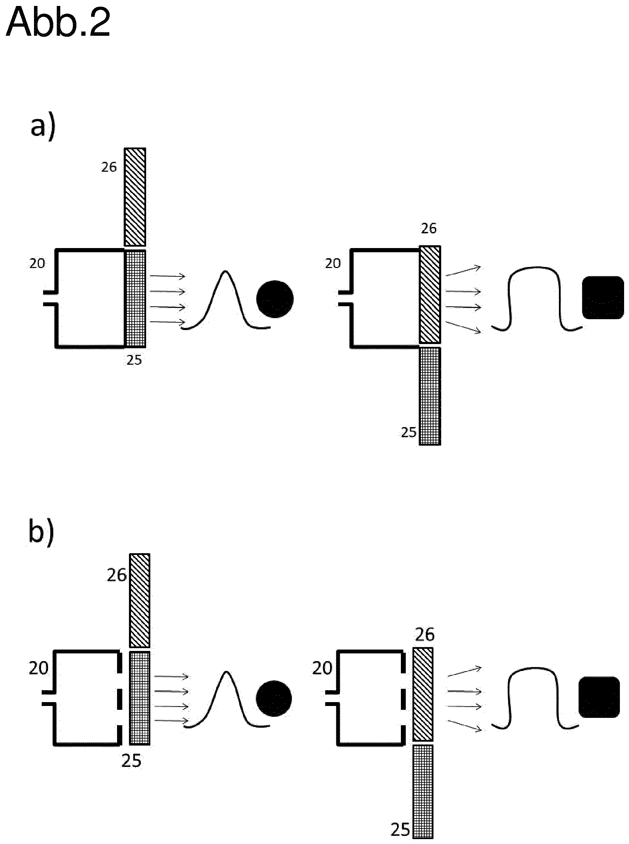

Grundsätzlich sind drei Ausgestaltungsformen des Ionenoptikwechslers 28 denkbar:
In einer ersten Ausgestaltung der erfindungsgemäßen Vorrichtung des Ionenoptikwechslers 28 werden die gesamten Ionenoptiken 25,26 ausgetauscht. Hierzu wird entweder durch Translations- oder Rotationsbewegung die gesamte Ionenoptik 25 gegen die gesamte Ionenoptik 26 ausgetauscht. (Abbildung 2a)

In einer zweiten Ausgestaltung des Ionenoptikwechslers 28 kann das erste Lochgitter des Extraktionssystems, der sogenannte Plasmagrenzanker, am Plasmagefäß 20 der lonenquelle verbleiben. Folglich werden nur die weiteren extraktionsseitigen Gitter von Ionenoptik 25 gegen die von Ionenoptik 26 ausgetauscht. Diese Ausgestaltung hätte die weitere Eigenschaft, dass das bereits im Ionentriebwerk befindliche Plasma in diesem Zustand verbleiben könnte. (Abbildung 2b)

In einer zweiten generellen Ausführungsform der Erfindung umfasst die erfindungsgemäße Vorrichtung 10 ein Steuerungsmittel 40 zur Einstellung des Strahlprofiles der lonenquelle aus Plasmagefäß 20 und Ionenoptik 25 bzw. 26 und der Einstellung des Ionenoptikwechslers 28.

Zum Steuerungsmittel 40 können beispielsweise zusätzlich gehören: Blenden z.B. zum Abblenden des Sekundärplumes in Beschichtungsprozessen, Magnete z.B. zur Formung des Sekundärplumes in Beschichtungsprozesses oder zur weiteren Modifikation des lonenstrahls beim Einsatz als Ionentriebwerk, Stellmotoren zum Bewegen einer oder mehrerer lonenquelle im Falle der Materialbearbeitung oder des Triebwerkeinsatzes oder Stellmotoren zum Bewegen des zu beschichtenden Objektes. Die Verwendung weiterer Bauelemente ist möglich.

In einer dritten Ausführungsform umfasst die erfindungsmäße Vorrichtung 10 zusätzlich ein Auswertemittel 30. Dieses dient dazu, Oberflächendaten der zu beschichtenden Oberfläche im Falle der Materialbearbeitung oder Daten über mögliche Strahlparameter und Strahlprofile der lonenquelle aus Plasmagefäß 20 und Ionenoptik 25 oder 26 in der Materialbearbeitung oder im Triebwerksbetrieb zu empfangen und (zwischen) zu speichern. Weiterhin dient das Auswertemittel 30 dazu, aus diesen Daten einen Bestrahlungsplan im Falle der Materialbearbeitung oder einen Betriebsplan im Falle des Ionentriebwerks zu erstellen und diesen an eine Steuerungsmittel 40 zu senden.

Als Auswertemittel 30 dient dabei ein Gerät zur elektronischen Datenverarbeitung z. B. ein in die Vorrichtung integrierter programmierbarer Mikroprozessor. Das Auswertemittel 30 ist weiterhin so ausgebildet, dass es die Ergebnisse eines Erfassungsmittels 50 und/oder eines Eingabemittels 60 auswerten und die Resultate an ein Steuerungsmittel 40 übermitteln kann.

Die Oberflächendaten sind dabei in einer internen Datenbank des Auswertemittels 30 hinterlegt oder werden durch einen Datenaustausch mit einer externen Datenbank beispielsweise über ein Netzwerk oder durch einen Datenaustausch mit einem Erfassungsmittel 50 bezogen. Dazu weist das Auswertemittel 30 vorzugsweise eine Schnittstelle zum elektronischen Datenaustausch (engl. electronic data interchange, EDI) auf.

Die Datenübertragung kann über eine feste Datenleitung oder drahtlos beispielsweise über eine Funkverbindung erfolgen.

Die Daten über mögliche Strahlprofile der lonenquelle bestehend aus Plasmagefäß 20 und Ionenoptik 25 oder 26 sind dabei in einer internen Datenbank des Auswertemittels 30 hinterlegt oder werden durch einen Datenaustausch mit einer externen Datenbank beispielsweise über ein Netzwerk oder durch einen Datenaustausch mit einem Eingabemittel 60 bezogen.

In einer vierten Ausführungsform umfasst die erfindungsgemäße Vorrichtung 10 weiterhin noch ein Eingabemittel 60. Das Eingabemittel 60 dient dazu, die Daten über mögliche Strahlprofile der lonenquelle bestehend aus Plasmagefäß 20 und Ionenoptik 25 oder 26 einzugeben und an das Auswertemittel 30 zur weiteren Verarbeitung zu übertragen. Zusätzlich können noch je nach Verwendung der erfindungsgemäßen Vorrichtung zur Erzeugung von lonenstrahlen Daten über gewünschte Schichtdickenprofile bei einer Nutzung in einer Beschichtungsanlage oder über verschiedene Betriebsmodi für den Betrieb als Gitter-Ionentriebwerke mit dem Eingabemittel 60 eingegeben werden. Beim Eingabemittel 60 kann es sich um eine Tastatur oder um eine grafische Benutzeroberfläche oder auch grafische Benutzerschnittstelle (Abk. GUI von englisch *graphical user interface*) handeln.

In einer fünften Ausführungsform insbesondere für die Materialbearbeitung umfasst die erfindungsgemäße Vorrichtung 10 weiterhin noch ein Erfassungsmittel 50. Das Erfassungsmittel 50 dient dazu, die Oberfläche eines zu beschichtenden Objektes 100 mit dem Erfassungsmittel 50 (z. B. einer Kamera) zu erfassen und die Oberflächendaten dann an das Auswertemittel 30 zur weiteren Verarbeitung zu übertragen. Einsatz des Erfassungsmittels 50 kann alternativ oder ergänzend zum Eingabemittel 60 erfolgen.

Dieser Austausch der Ionenoptiken ermöglicht den Einsatz grundverschiedener Extraktionssysteme vor ein und demselben Plasmagefäß 20. Vorteil gegenüber bisherigen Ansätzen mit mehreren Ionenquellen ist, dass man nur eine Gas- und eine elektrische Versorgung vorhalten muss. Ebenso kann man einem Wechsel des Betriebsmittels sowohl bei der terrestrischen Anwendung als auch bei der extraterrestrischen Anwendung leicht Rechnung tragen.

Im Falle der Materialdeposition ist es ein Vorteil, dass die Anordnung mit nur einer lonenquelle bzgl. Target und zu beschichtendem Objekt einfacher, weniger fehleranfällig und platzsparender ist, als die Anordnung mit mehreren Ionenquellen.

Neben bisher beschriebenen Anwendungen in der Oberflächenbeschichtung kann die erfindungsgemäße Vorrichtung auch für gezielten Oberflächenabtrag (z.B. lonenstrahlätzen) Verwendung finden. Hier können die Strahlprofile kombiniert werden, um eine höchstgenaue, gezielte Strukturierung der bearbeiteten Oberfläche herbeizuführen.

Im Falle des Einsatzes von Gitter-Ionenquellen als Ionentriebwerke auf Satelliten oder anderen Raumfahrzeugen sind für das gleiche Triebwerk oft je nach Aufgabenstellung (orbit raising, station keeping, deep space mission) verschiedene Betriebsmodi des Ionentriebwerks vorgesehen, z.B. hoher Schub oder hoher spezifischer Impuls. Letzterer ist dabei eine Art Gütefaktor für die Treibstoffnutzung. Je höher der Wert des spezifischen Impulses ist, desto mehr Schub bekommt man pro Kilo Treibstoff oder umso länger kann die Extraktion des Triebwerkes aktiv sein. Aktuell wird beim Extraktionssystem ein Kompromiss zwischen Schub und spezifischem Impuls geschlossen. Ein Wechsel des Gittersystems je nach Betriebsmodus oder ein Auswechseln des beim Aufspiralvorgang (engl. orbit raising) verschlissenen Gitters wäre von großem Vorteil. Der flexible Tausch des Extraktionssystems könnte die Effizienz des Triebwerks im jeweiligen Betriebsmodus durch das Nutzen einer optimal auf den Betriebsmodus zugeschnittenen Ionenoptik erhöhen. Darüber hinaus steigt die Lebensdauer des Extraktionssystems und damit auch des Triebwerks als Ganzem, weil der Materialabtrag am Gitter bei auf den Betriebspunkt optimierter Ionenoptik am geringsten ist.

### Abbildungslegende

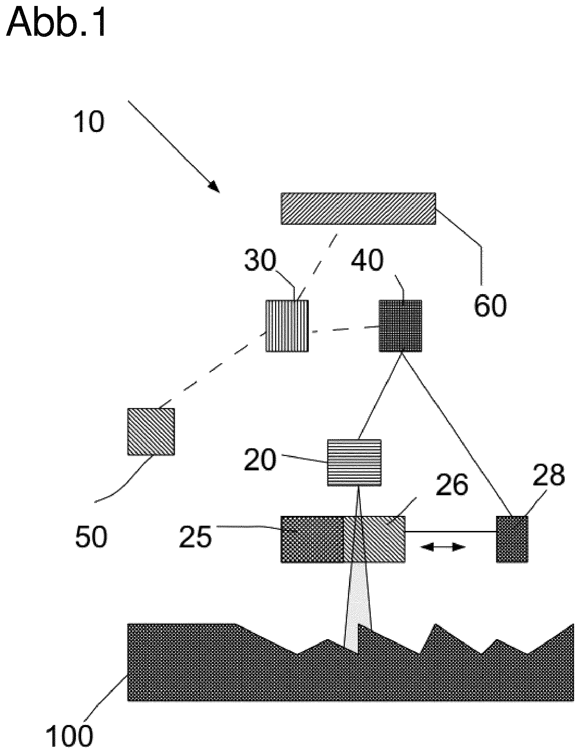

Abb. 1 Schematische Darstellung der erfindungsgemäßen Vorrichtung 10 zur Erzeugung von lonenstrahlen mit anpassbaren Ionenstrahlprofilen, wobei das gezeigte Auswertemittel 30, Steuerungsmittel 40, Erfassungsmittel 50 und das Eingabemittel 60 optional sind. Das mittels lonenstrahl zu bearbeitende Objekt 100 ist nur im Falle einer materialwissenschaftlichen Anwendung relevant.

Abb. 2: Schematische Darstellung der Funktion des Gitterwechslers. (a) Tausch der gesamten Ionenoptik, (b) Tausch der Ionenoptik bei gleichem Plasmagrenzanker.

### Bezugszeichenliste

10 Vorrichtung zur Erzeugung von lonenstrahlen mit anpassbaren Ionenstrahlprofilen
20 Plasmagefäß
25,26 Ionenoptiken
28 Ionenoptikwechsler
30 Auswertemittel
40 Steuerungsmittel
50 Erfassungsmittel
60 Eingabemittel
100 zu bearbeitendes Objekt

## Patentansprüche

1. Vorrichtung (10) zur Erzeugung von lonenstrahlen mit definierten Ionenstrahlprofilen umfassend:
wenigstens eine lonenquelle mit einem ein Plasmagefäß (20) mit wenigstens zwei Ionenoptiken (25,26) **dadurch gekennzeichnet, dass** die Vorrichtung (10) einen einem Ionenoptikwechsler (28) aufweist, wobei der Ionenoptikwechsler (28) so ausgebildet ist, dass er zwischen den Ionenoptiken (25,26) schaltet, so dass ein von der lonenquelle emittierter lonenstrahl in einem ersten Schaltzustand des Ionenoptikwechslers (28) eine erste lonenoptik (25) durchlaufen kann, wobei ein lonenstrahl mit einem ersten lonenstrahlprofil erzeugt wird und in wenigstens einem weiteren Schaltzustand alternativ eine zweite Ionenoptik (26)durchlaufen kann, wobei ein lonenstrahl mit einem alternativen Ionenstrahlprofil, welches vom ersten lonenstrahlprofil abweichen kann, erzeugt wird.

2. Vorrichtung (10) gemäß Anspruch 1 **dadurch gekennzeichnet, dass** diese weiterhin ein Steuerungsmittel (40) zur Steuerung des Ionenoptikwechslers (28) umfasst, zur Anpassung des Ionenstrahlprofiles.

3. Vorrichtung (10) gemäß Anspruch 2 **dadurch gekennzeichnet, dass** diese weiterhin ein Auswertemittel (30) umfasst zum Empfang und (Zwischen-)speicherung von Oberflächendaten einer Oberfläche eines zu bearbeitenden Objektes (100) zusammen mit den Daten über mögliche Strahlprofile, sowie zur Erstellung eines Bestrahlungsplan aus diesen Daten im Rahmen und zur Weiterleitung des erstellten Bestrahlungsplans an das Steuerungsmittel (40).

4. Vorrichtung (10) gemäß einem der Ansprüche 2 bis 4 im **dadurch gekennzeichnet, dass** diese weiterhin ein Eingabemittel (60) zur Eingabe der Daten über mögliche Ionenstrahlprofile umfasst.

5. Vorrichtung (10) gemäß Anspruch 2 oder 4 **dadurch gekennzeichnet, dass** diese weiterhin ein Erfassungsmittel (50) umfasst zu Erfassung der Oberflächendaten der zu bearbeitenden Oberfläche und zur Übertragung der Oberflächendaten an das Auswertemittel (30) zur weiteren Verarbeitung.

6. Ionentriebwerk **dadurch gekennzeichnet, dass** es eine Vorrichtung (10) gemäß einem der Ansprüche 1,2 oder 4 aufweist.

7. Verwendung einer Vorrichtung gemäß einem der Ansprüche 1 bis 5 zur Materialbearbeitung einer Oberfläche eines zu bearbeitenden Objektes (100).
